(19) Europäisches Patentamt
European Patent Office
Office européen des brevets

(11) **EP 3 984 750 B1**

(12) **EUROPEAN PATENT SPECIFICATION**

(45) Date of publication and mention
of the grant of the patent:
**02.07.2025 Bulletin 2025/27**

(21) Application number: **20823150.6**

(22) Date of filing: **12.06.2020**

(51) International Patent Classification (IPC):
**B41J 11/00** *(2006.01)*     **B41J 29/377** *(2006.01)*
**B41F 23/04** *(2006.01)*

(52) Cooperative Patent Classification (CPC):
**B41J 29/377; B41J 11/00212; B41J 11/00214;**
B41F 23/045

(86) International application number:
**PCT/JP2020/023311**

(87) International publication number:
**WO 2020/251048 (17.12.2020 Gazette 2020/51)**

(54) **LIGHT SOURCE DEVICE**

LICHTQUELLENVORRICHTUNG

DISPOSITIF DE SOURCE DE LUMIÈRE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **13.06.2019 JP 2019110338**

(43) Date of publication of application:
**20.04.2022 Bulletin 2022/16**

(73) Proprietor: HOYA CORPORATION
**Shinjuku-ku
Tokyo 160-8347 (JP)**

(72) Inventor: **WU, Lisong
Tokyo 160-8347 (JP)**

(74) Representative: **Dr. Schön, Neymeyr & Partner
Patentanwälte mbB
Bavariaring 26
80336 Munich (DE)**

(56) References cited:
JP-A- 2006 147 373     JP-A- 2007 087 816
JP-A- 2010 197 500     US-A1- 2011 096 300
US-A1- 2015 221 844     US-A1- 2018 160 564

**Description**

**BACKGROUND** OF THE DISCLOSURE

Field of the disclosure

The present disclosure relates to a light source device that emits light and, more particularly, to a light source device including a cooling fan for cooling heat emitted from the light source.

Related Art

Conventionally, a printing apparatus for printing, which uses UV ink cured by irradiating a target with ultraviolet light, is known. Such a printing apparatus is provided with an ultraviolet ray irradiating device and configured to discharge ink on a medium from a nozzle of a head and irradiate ultraviolet light on dots formed on the medium. As a light source for the ultraviolet ray irradiating device, a plurality of ultraviolet LEDs is used (e.g., Patent document 1).

The ultraviolet ray irradiating device disclosed in Patent document 1 is provided with an ultraviolet ray irradiation head having a plurality of ultraviolet LED elements as a light source and a control unit for lighting control of the LED element. As such, when the LED is used for a light source, since most of the power input is transformed to heat, a problem occurs in that lighting efficiency and life of the LED element become deteriorated by the heat emitted from the LED element itself. Furthermore, the problem becomes serious considering the fact that the number of LED elements, which are a heat source, is increased when a plurality of LED elements is mounted in the ultraviolet ray irradiating device disclosed in Patent document 1. For this reason, the ultraviolet ray irradiating device disclosed in Patent document 1 is provided with a heat sink for transferring heat generated in the LED element efficiently and a plurality of fan devices that provides cooling air to the heat sink and drives the fan device simultaneously with turning on the LED element and stops the fan device simultaneously with turning off the LED element, thereby suppressing heat dissipation of the LED element.

Prior art document

Patent document 1: Japanese patent No. 6349098
Patent document 2: US 2011/096300 A1
Patent document 3: US 2018/160564 A1

**SUMMARY**

According to the ultraviolet ray irradiating device disclosed in Patent document 1, the heat dissipation from the LED element can be suppressed by driving control of the fan device. However, the ultraviolet ray irradiating device disclosed in Patent document 1 drives the fan device simultaneously with turning on the LED element and stops the fan device simultaneously with turning off the LED element, and the housing of the ultraviolet ray irradiating device becomes full of heat when the LED element is turned off, and thus, there is a problem in that the housing is not cooled more although the LED element is turned off. In addition, when the LED element is turned on, the fan device rotates in the maximum number of revolutions always when the LED element is turned on, so it is easy to inhale dust from an intake hole (or fan device) and the risk of breakdown becomes increased. Furthermore, when the time for the fan device to rotate in the maximum number of revolutions increases, the life of the fan device becomes shorter.

In order to solve the problem above, the present disclosure is to provide a light source device which is capable of suppressing the state that the housing is full of heat when the LED element is turned off and reducing the risk of inhaling dust into the housing or the risk of reduction of life of the fan device.

In an aspect, a light source device according to the present disclosure includes a light source; a light source control unit for controlling turning on/off and a quantity of light of the light source; a cooling fan for cooling the light source; and a fan control unit for controlling a number of revolutions of the cooling fan, wherein the fan control unit is configured to: control the number of revolutions to drive the cooling fan at a first number of revolutions depending on the quantity of light of the light source when the light source is turned on, and control the number of revolutions to drive the cooling fan at a second number of revolutions lower than the first number of revolutions by waiting for a predetermined waiting time when the light source is turned off.

According to the configuration, since the fan continuously rotates even when the light source is turned off, there is no case that a housing is full of heat. In addition, since the number of revolutions of the fan is decreased while the light source is turned off, the risk of inhaling dust into the housing or the risk of reduction of life of the cooling fan becomes reduced.

According to the invention, a light source device according to the present disclosure includes a light source; a light source control unit for controlling turning on/off of the light source; a cooling fan for cooling the light source; and a fan control unit for controlling a number of revolutions of the cooling fan based on turning on/off of the light source, wherein the fan control unit is configured to: control the number of revolutions to drive the cooling fan at a first number of revolutions when the light source is turned on, and control the number of revolutions to drive the cooling fan at a second number of revolutions lower than the first number of revolutions by waiting for a predetermined waiting time when the light source is turned off.

In another aspect, a light source device according to the present disclosure includes a light source; a light source control unit for controlling turning on/off of the light source; a temperature sensor for detecting a temperature of the light source; a cooling fan for cooling the light source; and a fan control unit for controlling a number of revolutions of the cooling fan based on turning on/off of the light source and a detection result of the temperature sensor, wherein the fan control unit is configured to: control the number of revolutions of the cooling fan to become a first number of revolutions when the light source is turned on, and control the number of revolutions of the cooling fan to become a second number of revolutions lower than the first number of revolutions by waiting until the result of the temperature sensor becomes a predetermined value or smaller when the light source is turned off.

In addition, preferably, the fan control unit controls the number of revolutions of the cooling fan to satisfy Conditional equation 1 below when the first number of revolutions is R1, the second number of revolutions is R2, and a transition time from the first number of revolutions to the second number of revolutions is T.

[Conditional equation 1]

$$(R2-R1)/T=k \text{ (k is an arbitrary constant)}$$

In addition, preferably, when the light source is turned on within the transition time, the fan control unit does not wait for the transition time to be lapsed and controls the cooling fan such that the number of revolutions becomes the first number of revolutions.

In addition, preferably, the fan control unit controls the number of revolutions of the cooling fan to satisfy Conditional equation 2 below when the first number of revolutions is R1 and the quantity of light of the light source is P.

[Conditional equation 2]

$$R1=a \cdot P+b \text{ (a and b are arbitrary constants)}$$

In addition, preferably, the second number of revolutions is set to about 40% of a maximum number of revolutions of the cooling fan.

**ADVANTAGEOUS EFFECTS**

According to the present disclosure, a light source device is realized, in which the housing is not full of heat when the LED element is turned off, and the risk of inhaling dust into the housing or the risk of reduction of life of the fan device becomes reduced.

**BRIEF DESCRIPTION OF THE DRAWINGS**

FIG. 1 is an exterior view illustrating a light emitting device according to an exemplary embodiment of the present disclosure.
FIG. 2 is a diagram illustrating an internal configuration of the light emitting device according to an exemplary embodiment of the present disclosure.
FIG. 3 is a block diagram illustrating an electrical connection of the internal configuration of the light emitting device according to an embodiment of the present disclosure.
FIG. 4 is a flowchart of a control program executed in the light emitting device according to an exemplary embodiment of the present disclosure.
FIG. 5 is a timing chart corresponding to the flowchart shown in FIG. 4.
FIG. 6 is a block diagram illustrating an electrical connection of the internal configuration of a light emitting device according to a first modified example of the present disclosure.

FIG. 7 is a flowchart of a control program executed in the light emitting device according to the modified example of the present disclosure.

FIG. 8 is a flowchart of a control program executed in a light emitting device according to a second modified example of the present disclosure.

FIG. 9 is a timing chart corresponding to the flowchart shown in FIG. 8.

## DESCRIPTION OF EXEMPLARY EMBODIMENTS

Hereinafter, the embodiments of the present disclosure will be described with reference to drawings in detail. In addition, the same reference numeral is attached to the same or corresponding part in the drawings, and the description will not be repeated.

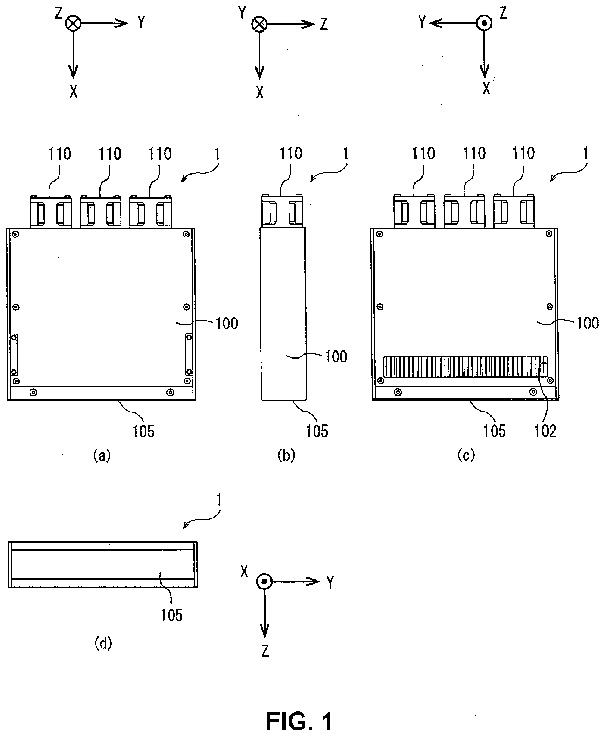

FIG. 1 is an exterior view illustrating a light emitting device (light resource apparatus) 1 according to an exemplary embodiment of the present disclosure, and FIG. 1(a) is a top plan view of the light emitting device (light resource apparatus) 1 according to an exemplary embodiment of the present disclosure. Further, FIG. 1(b) is a right side view of the light emitting device (light resource apparatus) 1 of FIG. 1(a), FIG. 1(c) is a bottom view of the light emitting device (light resource apparatus) 1 of FIG. 1(a), and FIG. 1(d) is a front view of the light emitting device (light resource apparatus) 1 of FIG. 1(a). The light emitting device 1 according to an exemplary embodiment is a light resource apparatus mounted on a printing apparatus and cures ultraviolet ray curing ink or ultraviolet ray curing resin. The light emitting device 1 is disposed on an upper direction of a target object and emits an ultraviolet ray in a line shape on the target object. In the present disclosure, as shown in the coordinate of FIG. 1, the direction of emitting an ultraviolet ray from a Light Emitting Diode (LED) element 210 to be described below is defined as an X direction, the direction of an arrangement of the LED 210 is defined as a Y direction, and the direction orthogonal to the X direction and the Y direction is defined as a Z direction.

As shown in FIG. 1, the light emitting device 1 according to an exemplary embodiment is provided with a case (housing) 100 of a thin box shape that accommodates a light source unit 200 or a heat sink member 400, a window part 105 attached to a front surface of the case 100 and made of glass through which an ultraviolet ray is emitted, and three fans (cooling fans) 110 installed on a rear surface of the case 100 which exhausts air in the case 100. Further, an intake hole 102 that intakes air from exterior is formed on a bottom surface of the case 100.

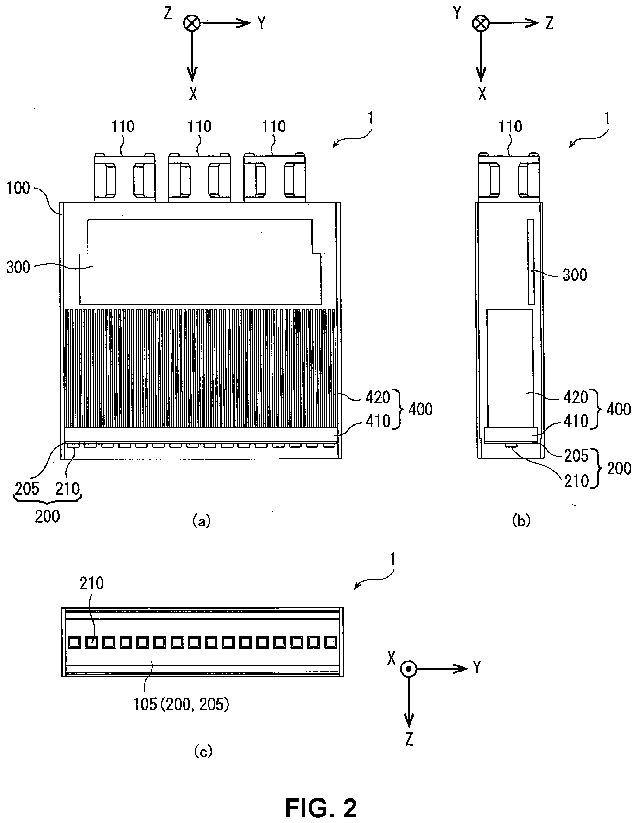

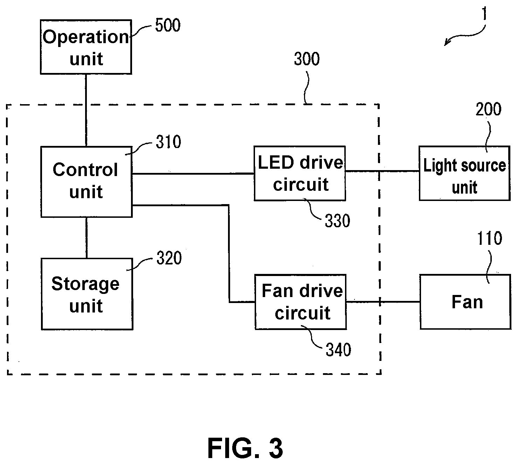

FIG. 2 is a diagram illustrating an internal configuration of the light emitting device 1 according to an exemplary embodiment of the present disclosure, and FIG. 2(a) is a plan perspective view of the light emitting device 1. FIG. 2(b) is a right side perspective view of the light emitting device 1. FIG. 2(c) is a front perspective view of the light emitting device 1. In addition, FIG. 3 is a block diagram illustrating an electrical connection of the internal configuration of the light emitting device 1 according to an embodiment.

As shown in FIG. 2, the light emitting device 1 according to an exemplary embodiment is provided with the case 100 including the light source unit 200, a control substrate 300, and the heat sink member 400.

As shown in FIG. 2, the light source unit 200 includes a substrate 205 of a rectangular shape defined in the Y direction and the Z direction and sixteen LED elements 210 having the same property.

The sixteen LED elements 210 are arranged on a surface of the substrate 205 along a line to be spaced apart in a predetermined distance in the Y direction while the optical axis thereof is arranged in the X direction and electrically connected with the substrate 205. The substrate 205 is connected to an LED drive circuit 330 on the control substrate 300 through a cable (not shown), and a driving current from the LED drive circuit 330 is applied to each LED element 210 through the substrate 205 (refer to FIG. 3). When the driving current is applied to each LED element 210, an ultraviolet ray (e.g., wavelength of 365 nm) of the quantity of light depending on the driving current is emitted from each LED element 210, and an ultraviolet ray of a line shape which is parallel with the Y direction is emitted from the light source unit 200. Furthermore, the driving current applied to each LED element 210 is adjusted such that each LED element 210 of an exemplary embodiment emits an ultraviolet ray of about the same quantity of light, and the ultraviolet ray of a line shape emitted from the light source unit 200 has uniform distribution of quantity of light with respect to the Y direction. In addition, in an exemplary embodiment, a user manipulates an operation unit 500 (not shown in FIGS. 1 and 2) connected to the control substrate 300, and thus, the quantity of light of the ultraviolet ray emitted from the light source unit 200 may be adjusted (described in detail below).

The heat sink member 400 is a part of dissipating heat emitted from the light source unit 200. The heat sink member 400 according to an exemplary embodiment is disposed close to a rear surface of the substrate 205 of the light source unit 200 and includes a base plate 410 of a planar shape that conducts heat emitted from each LED element 210 and a heat sink fin 420 installed uprightly in a direction opposite to the X direction which dissipates heat transferred to the base plate 410 to air (refer to FIG. 2(a) and (b)). When the fan 110 rotating air in the case 100 is exhausted from fan 110, external air is taken in from the intake hole 102. And then, an air current is generated such that the air taken in from the intake hole 102 flows on a surface of the heat sink fin 420, and thus, the heat sink fan 420 is efficiently cooled.

As shown in FIG. 3, the control substrate 300 is a circuit substrate that includes a control unit 310, a storage unit 320, the LED drive circuit 330, and a fan drive circuit 340 and controls the light source unit 200 and the fan 110.

The control unit 310 includes a CPU for executing a logical operation and a RAM that temporarily stores data and has the function of controlling the entire light emitting device 1. The control unit 310 is electrically connected to the storage unit 320, the LED drive circuit 330, the fan drive circuit 340, and the operation unit 500. When a power source is input to the light emitting device 1, the control unit 310 reads a control program stored in the storage unit 320 and controls each of the elements. That is, the control unit 310 according to an exemplary embodiment has both the function of controlling the LED drive circuit 330 (light source control unit ) and the function of controlling the fan drive circuit 340 (fan control unit).

The storage unit 320 is a non-volatile memory that stores a control program executed in the control unit 310.

The operation unit 500 is a user interface in which an input from a user is performed and configured to set adjustment of a quantity of light of the ultraviolet ray emitted from the light source unit 220, turning on/off of the ultraviolet ray, and the like through the operation unit 500.

The LED drive circuit 330 is a circuit that is electrically connected to the light source unit 220 and supplies a driving current to each LED element 210. The LED drive circuit 330 turns on and off the LED element 210 and outputs a predetermined driving current to the LED element 210 according to an instruction (signal) from the control unit 310.

The fan drive circuit 340 is a circuit that is electrically connected to the fan 110 and supplies driving power to the fan 110. The fan drive circuit 340 turns on and off the fan 110 and rotates the fan 110 at a predetermined number of revolutions according to an instruction (signal) from the control unit 310.

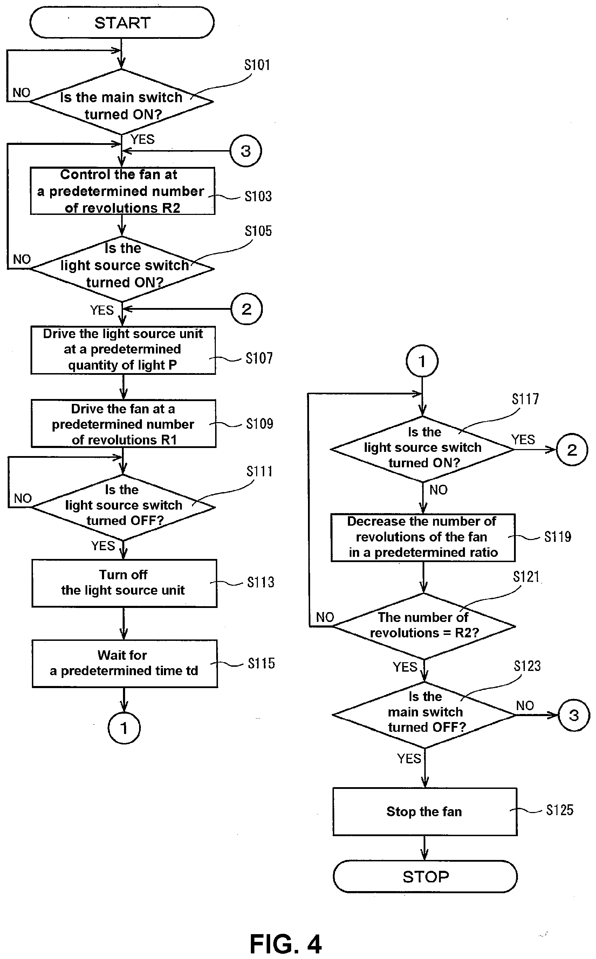

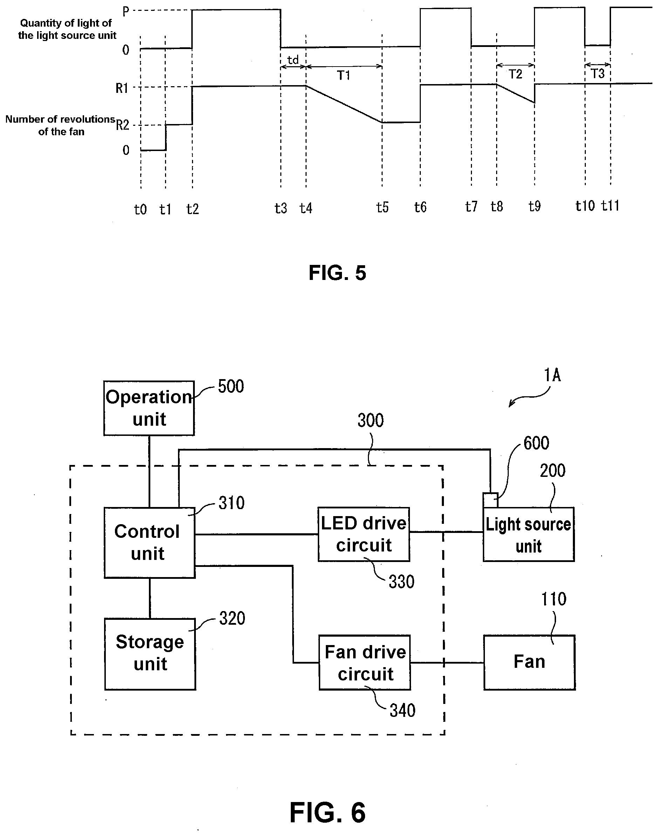

Subsequently, with reference to the flowchart of FIG. 4, the control program executed in the control unit 310 is described. The control program is read from the storage unit 320 and executed in the control unit 310 when power source is input to the light emitting device 1. FIG. 5 is a timing chart corresponding to each step of the control program shown in FIG. 4 and illustrates the appearance of the light source unit 200 and the fan 110 in each step of the control program.

As shown in FIG. 4, when the control program is executed, the control unit 310 determines whether a user turns ON a main switch of the light emitting device 1 through the operation unit 500. In the case that it is determined that the main switch is not turned ON (step S101; NO), step S101 is repeated until the main switch is turned ON, and the light source unit 200 and the fan 110 maintain a state of OFF (i.e., the quantity of light of ultraviolet ray: 0 and the number of revolutions of the fan: 0) (t0 ~ t1 of FIG. 5). In addition, when the main switch is turned ON (step S101; YES), the operation progresses to step S103.

In step S103, the control unit 310 controls the fan drive circuit 340 to drive the fan 110 at a predetermined number of revolutions R2 (e.g., 40% of the revolution per minute (rpm) of a maximum number of revolutions) (refer to FIG. 5; t1). When the operation of step S103 is terminated, the operation progresses to step S105.

In step S105, the control unit 310 determines whether a user turns ON a light source switch (a switch for functioning the light source unit 200) through the operation unit 500. In the case that it is determined that the light source switch is not turned ON (step S105; NO), steps S103 and S105 are repeated until the light source switch is turned ON (refer to FIG. 5; t1 ~ t2), and in the case that light source switch is turned ON (step S105; YES), the operation progresses to step S107.

In step S107, the control unit 310 controls the LED drive circuit 330 to supply a driving current to each LED element 210 of the light source unit 200 such that the quantity of light of the ultraviolet ray emitted from the light source unit 200 becomes a predetermined quantity of light P (W) (refer to FIG. 5; t2). When the operation of step S107 is terminated, the operation progresses to step S109.

In step S109, the control unit 310 controls the fan drive circuit 340 to drive the fan 110 at a predetermined number of revolutions R1 which is higher than the number of revolutions R2 (e.g., 90% revolution per minute (rpm) of the maximum number of revolutions) (refer to FIG. 5; t2). In addition, in an exemplary embodiment, the number of revolutions R1 is set to the number of revolutions depending on the quantity of light P such that $R1 = a \times P$ (a is an arbitrary constant). When the operation of step S109 is terminated, the operation progresses to step S111.

In step S111, the control unit 310 determines whether a user turns OFF the light source switch through the operation unit 500. In the case that it is determined that the light source switch is not turned OFF (step S111; NO), step S111 is repeated until the light source switch is turned OFF, and the light source unit 200 and the fan 110 maintain a state of ON (i.e., the quantity of light of ultraviolet ray: P and the number of revolutions of the fan: R1) (t2 ~ t3 of FIG. 5). In addition, when the light source switch is turned OFF (step S111; YES), the operation progresses to step S113.

In step S113, the control unit 310 controls the LED drive circuit 330 to turn off the ultraviolet ray emitted from the light source unit 200 (refer to FIG. 5; t3). When the operation of step S113 is terminated, the operation progresses to step S115.

In step S115, the control unit 310 waits for a predetermined time td (e.g., 2 seconds) (refer to FIG. 5; t4), and the operation progresses to step S117.

In step S117, the control unit 310 determines whether a user turns ON the light source switch through the operation unit 500. In the case that it is determined that the light source switch is not turned ON (step S117; NO), the operation progresses to step S119. In the case that it is determined that the light source switch is turned ON (step S117; YES), the operation progresses to step S107.

In step S119, the control unit 310 controls the fan drive circuit 340 to drive the fan 110 such that the number of revolutions of the fan 110 is decreased in a predetermined ratio from the number of revolutions R1 to the number of revolutions R2 (refer to FIG. 5; t4 ~ t5). That is, as shown in FIG. 5, in an exemplary embodiment, when a transition time of decreasing the number of revolutions from the number of revolutions R1 to the number of revolutions R2 is denoted as T (e.g., 10 seconds), the control unit 310 controls the fan drive circuit 340 to satisfy Conditional equation 1 below.

[Conditional equation 1]

$$(R2-R1)/T=k \text{ (k is an arbitrary constant)}$$

When the operation of step S119 is terminated, the operation progresses to step S121.

In step S121, the control unit 310 identifies a configuration of the fan drive circuit 340 and determines whether the number of revolutions of the fan 110 becomes the number of revolutions R2. In the case that the number of revolutions of the fan 110 is not the number of revolutions R2 (step S121; NO), steps S117 to S121 are repeated (refer to FIG. 5; t4 ~ t5), and in the case that the number of revolutions of the fan 110 becomes the number of revolutions R2 (step S121; YES), the operation progresses to step S123 (refer to FIG. 5; t5).

In step S123, the control unit 310 determines whether a user turns OFF the main switch through the operation unit 500. In the case that it is determined that the main switch is not turned OFF (step S123; NO), the operation progresses to step S103, and in the case that it is determined that the main switch is turned OFF (step S123; YES), the control unit 310 stops the fan 110 (step S125) and terminates the control program.

As such, in the light emitting device 1 according to an exemplary embodiment (i.e., when the control program is executed), when a user turns ON the light source switch through the operation unit 500, the ultraviolet ray of a predetermined quantity of light P is emitted from the light source unit 200, and the fan 110 is driven at the number of revolutions R1 (refer to FIG. 5; t2 ~ t3). Further, when the light source switch is turned OFF, after the ultraviolet ray is turned off, for a predetermined time td, the number of revolutions of the fan 110 is gradually decreased (refer to FIG. 5; t3 ~ t5) and maintains the number of revolutions R2 (refer to FIG. 5; t5 ~ t6). That is, since the fan 110 continuously rotates even when the ultraviolet ray is turned off, there is no case that the case 100 is full of heat. In addition, since the number of revolutions of the fan 110 is decreased in the waiting state after the ultraviolet ray is turned off, the risk of inhaling dust in the case 100 or the risk of reduction of life of the fan 100 becomes reduced.

Furthermore, in FIG. 5, the interval t6 to t9 denotes a time line in the case that a user turns ON the light source switch through the operation unit 500 when the number of revolutions of the fan 110 is decreasing in step S119. That is, in FIG. 4, while steps S117 to S121 are repeated (refer to FIG. 5; t8 ~ t9), when turning ON of the light source switch is detected on time T2 which is shorter than the transition time T1, since the number of revolutions of the fan 110 is not decreased to the number of revolutions R2, the operation progresses to step S107 (step S117; YES). And then, the control unit 310 controls the LED drive circuit 330 to supply a driving current to each LED element 210 of the light source unit 200 such that the quantity of light of the ultraviolet ray emitted from the light source unit 200 becomes a predetermined quantity of light P (refer to FIG. 5; t9). As such, in an exemplary embodiment, when turning ON of the light source switch is detected during the transition time T1, the operation of steps S117 to S121 are stopped, and thus, the ultraviolet ray of a predetermined quantity of light P is emitted from the light source unit 200 and the fan 110 is driven at the number of revolutions R1 (refer to FIG. 5; t9).

In FIG. 5, the interval t9 to t11 denotes a time line in the case that a user turns ON the light source switch through the operation unit 500 when waiting for a predetermined time td in step S115. That is, in step S115 shown in FIG. 4, while waiting for a predetermined time td, when turning ON of the light source switch is detected, the operation progresses from step S117 to step S107 (i.e., there is not case of progressing to step S119). And then, the control unit 310 controls the LED drive circuit 330 to supply a driving current to each LED element 210 of the light source unit 200 such that the quantity of light of the ultraviolet ray emitted from the light source unit 200 becomes a predetermined quantity of light P (refer to FIG. 5; t11). As such, in an exemplary embodiment, when turning ON of the light source switch is detected while waiting for a predetermined time td (during the period of T3), the operations of steps S117 to S121 are not performed (i.e., the number of revolutions of the fan 110 is not decreased), and thus, the ultraviolet ray of a predetermined quantity of light P is emitted from the light source unit 200 and the fan 110 is driven to maintain the number of revolutions R1 (refer to FIG. 5; t11).

So far, the exemplary embodiment has been described, but the present disclosure is not limited to the configuration described above, and various modifications are available within the scope of the inventive concept of the present disclosure. For example, in step S109 of the exemplary embodiment, the number of revolutions R1 is configured as is $R1=a \times P$ (a is an arbitrary constant) (i.e., the number of revolutions R1 is in the relationship of proportional to the quantity of light P) but may be generalized to a linear function as represented in Conditional equation 2.

[Conditional equation 2]

R1=a·P+b (a and b are arbitrary constants)

The number of revolutions R1 and the quantity of light P are not necessarily in a proportional relationship, and the number of revolutions R1 may be set to a predetermined number of revolutions.

In the exemplary embodiment, it has been described that the number of revolutions R2 is 40% of the maximum number of revolutions, but the present disclosure is not limited thereto, and the number of revolutions R2 may be properly set according to the heat value of the light source unit 200 and the cooling capacity of the heat sink member 400 or the fan 110.

In addition, in step S115 according to the exemplary embodiment, it has been described that the control unit 310 waits for a predetermined time td (e.g., 2 seconds), but the present disclosure is not limited thereto, and the predetermined time td may be properly set according to the heat value of the light source unit 200 and the cooling capacity of the heat sink member 400 or the fan 110.

The light emitting device 1 according to the exemplary embodiment has been described that the heat sink member 400 is disposed in the case 100, but the light source unit 200 may be cooled down by the fan 110, and thus, the heat sink member 400 is optional.

(First modified example)

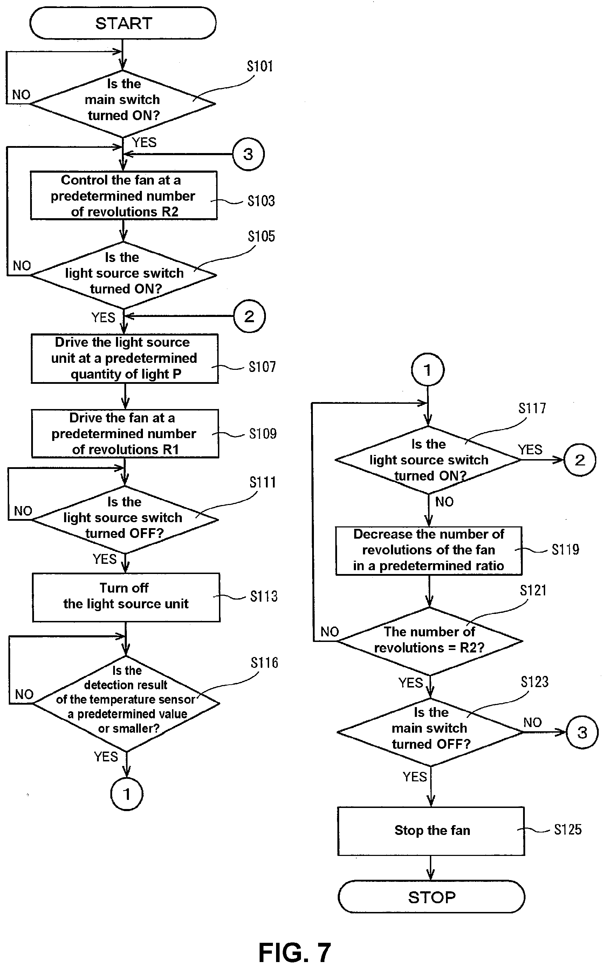

FIG. 6 is a block diagram illustrating an electrical connection of the internal configuration of a light emitting device 1A according to a first modified example. In addition, FIG. 7 is a flowchart of a control program executed in the control unit 310 of the modified example.

As shown in FIG. 6, the light emitting device 1A according to the modified example is different from the configuration of the exemplary embodiment in the fact that the light emitting device 1A has a temperature sensor 600 that detects a temperature of the light source unit 200 and has step S116 instead of step S115 of the control program of the exemplary embodiment.

That is, in the modified example, after the light source switch is turned OFF (steps S111 and S113), the control unit 310 waits until a detection result of the temperature sensor 600 becomes a predetermined value (e.g., 40°) or smaller (step S116; NO), and when the detection result of the temperature sensor 600 becomes the predetermined value or smaller, the control unit 310 decreases the number of revolutions of the fan 110 gradually (steps S117 ~ S121). As such, according to the modified example, the number of revolutions of the fan 110 is controlled based on the detection result of the temperature sensor 600, and the light source unit 200 may be properly cooled down.

(Second modified example)

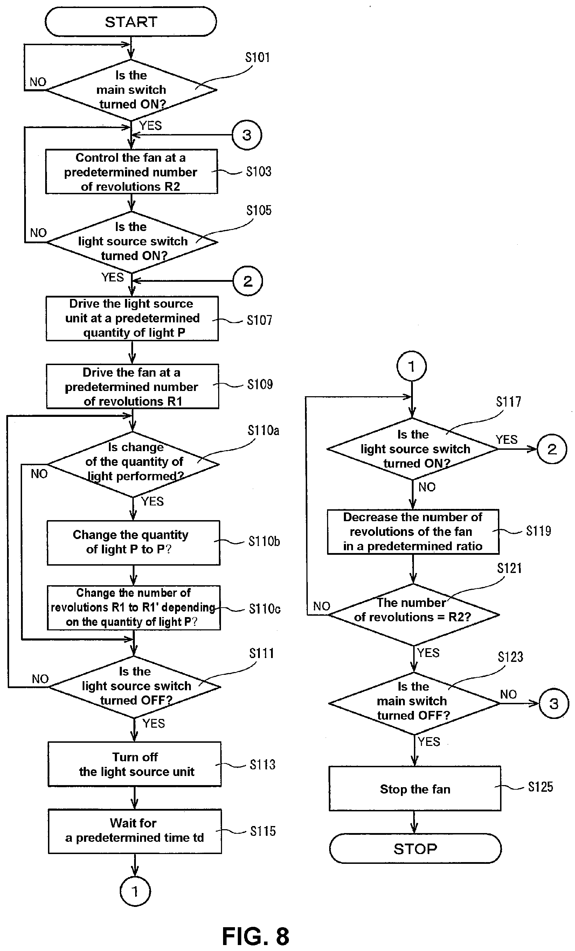

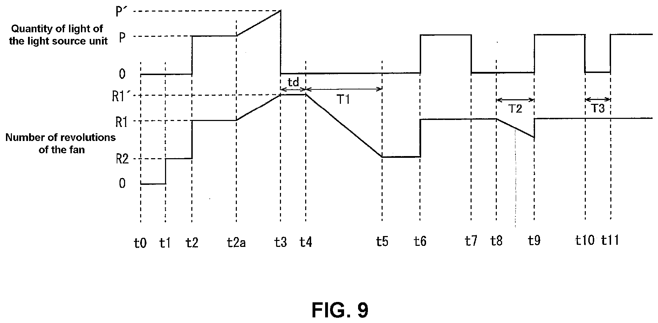

FIG. 8 is a flowchart of a control program executed in the control unit 310 of a light emitting device 1B (not shown in FIG. 8) according to a second modified example. In addition, FIG. 9 is a timing chart corresponding to each step of the control program shown in FIG. 8, which shows the feature of the light source unit 200 and the fan 110 in each step of the control program. The configuration of the light emitting device 1B according to the second modified example is the same as the light emitting device 1 of the exemplary embodiment, but only the control program is different.

As shown in FIG. 8, the control program of the light emitting device 1B according to the modified example is different from the control program of the light emitting device 1 of the exemplary embodiment in the fact that the control program of the light emitting device 1B has steps S110a, S110b, and S110c between step S109 and step S101.

In step S110a, the control unit 310 determines whether a user manipulates a change of the quantity of light through the operation unit 500 (i.e., whether a user manipulates the quantity of light P to be changed). When it is determined that a manipulation of changing the quantity of light is not performed (step S110a: NO), the operation progresses to step S111, and when it is determined that a manipulation of changing the quantity of light is performed (step S110a: YES), the operation progresses to step S110b.

In step S110b, the control unit 310 controls the LED drive circuit 330 based on a user manipulation which is input to the operation unit 500 to supply a driving current to each LED element 210 of the light source unit 200 such that the ultraviolet ray emitted from the light source unit 200 becomes a predetermined quantity of light P' (P' is a quantity of light after change) (refer to FIG. 9; t2a). When the operation of step S110b is terminated, the operation is processing to step S110c.

In step S110c, the control unit 310 controls the fan drive circuit 340 according to the quantity of light P' in step S110b to change the number of revolutions R1 of the fan 110 to the number of revolutions R1' (refer to FIG. 9; t2a). That is, the number of revolutions is changed such that the number of revolutions R1 becomes R1'=a×P' (a is an arbitrary constant). When the operation of step S110c is terminated, the operation is processing to step S111.

In step S111, the control unit 310 determines whether a user turns OFF the light source switch through the operation unit 500. In the case that it is determined that the light source switch is not turned OFF (step S111; NO), the operation returns to step S109, and steps S110a to S110c are repeated (refer to FIG. 9; t2a ~ t3). In addition, when the light source switch is turned OFF (step S111; YES), the operation progresses to step S113.

As such, in the light emitting device 1B according to the modified example, when a user manipulates a change of the quantity of light through the operation unit 500, the quantity of light P is changed according to the user manipulation and depending on the quantity of light P' which is changed, the number of revolutions R1 is also changed to the number of revolutions R1' (refer to FIG. 9; t2a ~ t3). Further, when the light source switch is turned OFF, after the ultraviolet ray is turned off, by waiting for a predetermined time td, the number of revolutions of the fan 110 is gradually decreased (refer to FIG. 9; t3 ~ t5) and maintains the number of revolutions R2 (refer to FIG. 9; t5 ~ t6). That is, since the fan 110 continuously rotates even when the ultraviolet ray is turned off, there is no case that the case 100 is full of heat. In addition, since the number of revolutions of the fan 110 is decreased in the waiting state after the ultraviolet ray is turned off, the risk of inhaling dust in the case 100 or the risk of reduction of life of the fan 100 becomes reduced.

The exemplary embodiments disclosed so far are just exemplary for all aspects and are not intended to be restrictive. The scope of the present disclosure is interpreted by the claims.

[Detailed Description of Main Elements]

1: light emitting device
1A: light emitting device
1B: light emitting device
100: case
102: intake hole
105: window part
110: fan
200: light source unit
205: substrate
210: LED element
300: control substrate
310: control unit
320: storage unit
330: LED drive circuit
340: fan drive circuit
400: heat sink member
410: base plate
420: heat sink fin
500: operation unit
600: temperature sensor

**Claims**

1. A light source device (1) comprising:

   a light source (200);
   a light source control unit (330) for controlling turning on/off of the light source;
   a cooling fan (110) for cooling the light source; and
   a fan control unit (340) for controlling a number of revolutions of the cooling fan based on turning on/off of the light source,
   wherein the fan control unit is configured to:

      control the number of revolutions to drive the cooling fan at a first number of revolutions when the light source is turned on, and **characterized in that** the fan control unit is further configured to
      control the number of revolutions to drive the cooling fan at a second number of revolutions lower than the first number of revolutions by waiting for a predetermined waiting time when the light source is turned off.

2. The light source device of claim 1, wherein

the light source control unit is further configured to control a quantity of light of the light source; and wherein the fan control unit is configured to:

control the number of revolutions to drive the cooling fan at a first number of revolutions depending on the quantity of light of the light source when the light source is turned on, and
control the number of revolutions to drive the cooling fan at a second number of revolutions lower than the first number of revolutions by waiting for a predetermined waiting time when the light source is turned off.

3. The light source device of claim 1, further comprising:

a temperature sensor (600) for detecting a temperature of the light source;
wherein the fan control unit is configured to:
control the number of revolutions to drive the cooling fan at a second number of revolutions lower than the first number of revolutions by waiting until the detection result of the temperature sensor becomes a predetermined value or smaller when the light source is turned off.

4. The light source device of any one of claims 1 to 3, wherein the fan control unit controls the number of revolutions of the cooling fan to satisfy Conditional equation 1 below when the first number of revolutions is R1, the second number of revolutions is R2, and a transition time from the first number of revolutions to the second number of revolutions is T.

$$[\text{Conditional equation 1}]$$

$$(R2-R1)/T=k \text{ (k is an arbitrary constant)}$$

5. The light source device of claim 4, wherein, when the light source is turned on within the transition time, the fan control unit does not wait for the transition time to be lapsed and controls the cooling fan such that the number of revolutions of the cooling fan becomes the first number of revolutions.

6. The light source device of claim 2, wherein the fan control unit controls the number of revolutions of the cooling fan to satisfy Conditional equation 2 below when the first number of revolutions is R1 and the quantity of light of the light source is P.

$$[\text{Conditional equation 2}]$$

$$R1=a \cdot P+b \text{ (a and b are arbitrary constants)}$$

7. The light source device of any one of claims 1 to 6, wherein the second number of revolutions is set to about 40% of a maximum number of revolutions of the cooling fan.

**Patentansprüche**

1. Lichtquellenvorrichtung (1), die Folgendes umfasst:

eine Lichtquelle (200),
eine Lichtquellen-Steuereinheit (330) zum Steuern des Ein-/Ausschaltens der Lichtquelle,
einen Kühlventilator (110) zum Kühlen der Lichtquelle, und
eine Ventilator-Steuereinheit (340) zum Steuern der Anzahl der Umdrehungen des Kühlventilators basierend auf einem Ein-/Ausschalten der Lichtquelle,
wobei die Ventilator-Steuereinheit konfiguriert ist, die Anzahl der Umdrehungen so zu steuern, dass der Kühlventilator mit einer ersten Anzahl von Umdrehungen angetrieben wird, wenn die Lichtquelle eingeschaltet ist, und wobei
die Lichtquellenvorrichtung (1) **dadurch gekennzeichnet ist,**
**dass** die die Ventilator-Steuereinheit des Weiteren konfiguriert ist, die Anzahl der Umdrehungen so zu steuern, dass der Kühlventilator mit einer zweiten Anzahl von Umdrehungen angetrieben wird, die geringer als die erste Anzahl von Umdrehungen ist, durch Warten während einer vorgegebenen Wartezeit, wenn die Lichtquelle ausgeschaltet wird.

2. Lichtquellenvorrichtung gemäß Anspruch 1, wobei

die Lichtquellen-Steuereinheit des Weiteren konfiguriert ist, die Lichtmenge der Lichtquelle zu steuern, und wobei
die Ventilator-Steuereinheit konfiguriert ist,
die Anzahl der Umdrehungen so zu steuern, dass der Kühlventilator mit einer ersten Anzahl von Umdrehungen in Abhängigkeit von der Lichtmenge der Lichtquelle angetrieben wird, wenn die Lichtquelle eingeschaltet ist, und die Anzahl der Umdrehungen so zu steuern, dass der Kühlventilator mit einer zweiten Anzahl von Umdrehungen angetrieben wird, die geringer als die erste Anzahl von Umdrehungen ist, durch Warten während einer vorgegebenen Wartezeit, wenn die Lichtquelle ausgeschaltet wird.

3. Lichtquellenvorrichtung gemäß Anspruch 1, des Weiteren umfassend:

einen Temperatursensor (600) zum Erfassen einer Temperatur der Lichtquelle,
wobei die Ventilator-Steuereinheit konfiguriert ist, die Anzahl der Umdrehungen so zu steuern, dass der Kühlventilator mit einer zweiten Anzahl von Umdrehungen angetrieben wird, die geringer als die erste Anzahl von Umdrehungen ist, durch Warten, bis das Ergebnis der Erfassung des Temperatursensors einen vorgegebenen Wert erreicht oder niedriger ist, wenn die Lichtquelle ausgeschaltet wird.

4. Lichtquellenvorrichtung gemäß einem der Ansprüche 1 bis 3, wobei die Ventilator-Steuereinheit die Anzahl der Umdrehungen des Kühlventilators so steuert, dass die nachfolgende Bedingungsgleichung 1 erfüllt ist, wenn die erste Anzahl der Umdrehungen R1 ist, die zweite Anzahl der Umdrehungen R2 ist und eine Übergangszeit von der ersten Anzahl der Umdrehungen zur zweiten Anzahl der Umdrehungen T ist.

[Bedingungsgleichung 1]

$$(R2 − R1) / T = k \qquad \text{(k ist eine beliebige Konstante)}$$

5. Lichtquellenvorrichtung gemäß Anspruch 4, wobei, wenn die Lichtquelle innerhalb der Übergangszeit eingeschaltet wird, die Ventilator-Steuereinheit nicht wartet, bis die Übergangszeit abgelaufen ist, und den Kühlventilator so steuert, dass die Anzahl der Umdrehungen des Kühlventilators der ersten Anzahl von Umdrehungen entspricht.

6. Lichtquellenvorrichtung gemäß Anspruch 2, wobei die Ventilator-Steuereinheit die Anzahl der Umdrehungen des Kühlventilators so steuert, dass die nachfolgende Bedingungsgleichung 2 erfüllt ist, wenn die erste Anzahl der Umdrehungen R1 ist und die Lichtmenge der Lichtquelle P ist.

[Bedingungsgleichung 2]

$$R1 = a \cdot P+b \qquad \text{(a und b sind beliebige Konstanten)}$$

7. Lichtquellenvorrichtung gemäß einem der Ansprüche 1 bis 6, wobei die zweite Anzahl der Umdrehungen auf etwa 40 % einer maximalen Anzahl von Umdrehungen des Kühlventilators eingestellt ist.

**Revendications**

1. Dispositif de source de lumière (1) comprenant

une source de lumière (200) ;
une unité de commande de source de lumière (330) permettant de commander l'allumage/extinction de la source de lumière,
un ventilateur de refroidissement (110) permettant de refroidir la source de lumière ; et
une unité de commande de ventilateur (340) permettant de commander une vitesse de rotation du ventilateur de refroidissement sur la base de l'allumage/extinction de la source de lumière,

dans lequel l'unité de commande de ventilateur est configurée pour :

la commande de la vitesse de rotation pour entraîner le ventilateur de refroidissement à une première vitesse de rotation lorsque la source de lumière est allumée, et **caractérisé en ce que** l'unité de commande de ventilateur est en outre configurée pour
commander la vitesse de rotation pour entraîner le ventilateur de refroidissement à une deuxième vitesse de rotation inférieure à la première vitesse de rotation en attendant pendant un temps d'attente prédéterminé lorsque la source de lumière est éteinte.

2. Dispositif de source de lumière selon la revendication 1, dans lequel

l'unité de commande de source de lumière est en outre configurée pour commander une quantité de lumière de la source de lumière ; et dans lequel
l'unité de commande de ventilateur est configurée pour :

commander la vitesse de rotation pour entraîner le ventilateur de refroidissement à une première vitesse de rotation en fonction de la quantité de lumière de la source de lumière lorsque la source de lumière est allumée, et
commander la vitesse de rotation pour entraîner le ventilateur de refroidissement à une deuxième vitesse de rotation inférieure à la première vitesse de rotation en attendant pendant un temps d'attente prédéterminé lorsque la source de lumière est éteinte.

3. Dispositif de source de lumière selon la revendication 1, comprenant en outre :

un capteur de température (600) permettant de détecter une température de la source de lumière ;
dans lequel l'unité de commande de ventilateur est configurée pour :
commander la vitesse de rotation pour entraîner le ventilateur de refroidissement à une deuxième vitesse de rotation inférieure à la première vitesse de rotation en attendant jusqu'à ce que le résultat de détection du capteur de température atteigne une valeur prédéterminée ou soit en dessous de celle-ci lorsque la source de lumière est éteinte.

4. Dispositif de source de lumière selon l'une quelconque des revendications 1 à 3, dans lequel l'unité de commande de ventilateur commande la vitesse de rotation du ventilateur de refroidissement pour satisfaire l'équation conditionnelle 1 ci-dessous lorsque la première vitesse de rotation est R1, que la deuxième vitesse de rotation est R2 et qu'un temps de transition entre la première vitesse de rotation et la deuxième vitesse de rotation est T.

[Équation conditionnelle 1]

$$(R2-R1)/T = k \quad \text{(k étant une constante arbitraire)}$$

5. Dispositif de source de lumière selon la revendication 4, dans lequel, lorsque la source de lumière est allumée pendant le temps de transition, l'unité de commande de ventilateur n'attend pas que le temps de transition soit écoulé et commande le ventilateur de refroidissement de manière à ce que la vitesse de rotation du ventilateur de refroidissement atteigne la première vitesse de rotation.

6. Dispositif de source de lumière selon la revendication 2, dans lequel l'unité de commande de ventilateur commande la vitesse de rotation du ventilateur de refroidissement pour satisfaire l'équation conditionnelle 2 ci-dessous lorsque la première vitesse de rotation est R1 et que la quantité de lumière de la source de lumière est P.

[Équation conditionnelle 2]

$$R1 = a \cdot P + b \quad \text{(a et b étant des constantes arbitraires)}$$

7. Dispositif de source de lumière selon l'une quelconque des revendications 1 à 6, dans lequel la deuxième vitesse de rotation est fixée à environ 40 % de la vitesse de rotation maximale du ventilateur de refroidissement.

**FIG. 1**

**FIG. 2**

FIG. 3

**FIG. 4**

Quantity of light of
the light source unit

Number of revolutions
of the fan

**FIG. 5**

Operation
unit — 500

300

1A

600

200

Control
unit — 310

LED drive
circuit

Light source
unit

330

Storage
unit — 320

Fan drive
circuit

Fan

340

110

**FIG. 6**

EP 3 984 750 B1

START

S101 Is the main switch turned ON?
NO

YES ← ③

S103 Control the fan at a predetermined number of revolutions R2

S105 Is the light source switch turned ON?
NO

YES ← ②

S107 Drive the light source unit at a predetermined quantity of light P

S109 Drive the fan at a predetermined number of revolutions R1

S111 Is the light source switch turned OFF?
NO

YES

S113 Turn off the light source unit

S116 Is the detection result of the temperature sensor a predetermined value or smaller?
NO

YES

①

①

S117 Is the light source switch turned ON?
YES → ②

NO

S119 Decrease the number of revolutions of the fan in a predetermined ratio

S121 The number of revolutions = R2?
NO

YES

S123 Is the main switch turned OFF?
NO → ③

YES

S125 Stop the fan

STOP

**FIG. 7**

17

START

S101 — Is the main switch turned ON? — NO (loop back)

YES — ③

Control the fan at a predetermined number of revolutions R2 — S103

Is the light source switch turned ON? — S105 — NO (loop back)

YES — ②

Drive the light source unit at a predetermined quantity of light P — S107

Drive the fan at a predetermined number of revolutions R1 — S109

Is change of the quantity of light performed? — S110a — NO

YES

Change the quantity of light P to P? — S110b

Change the number of revolutions R1 to R1' depending on the quantity of light P? — S110c

Is the light source switch turned OFF? — S111 — NO

YES

Turn off the light source unit — S113

Wait for a predetermined time td — S115

①

①

Is the light source switch turned ON? — S117 — YES — ②

NO

Decrease the number of revolutions of the fan in a predetermined ratio — S119

The number of revolutions = R2? — S121 — NO

YES

Is the main switch turned OFF? — S123 — NO — ③

YES

Stop the fan — S125

STOP

**FIG. 8**

18

Quantity of light of
the light source unit

Number of revolutions
of the fan

P´
P
0
R1´
R1
R2
0

td
T1
T2
T3

t0 t1 t2 t2a t3 t4 t5 t6 t7 t8 t9 t10 t11

FIG. 9

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 6349098 B
- US 2011096300 A1

- US 2018160564 A1